# EUROPEAN PATENT SPECIFICATION

(11) **EP 3 726 821 B1**
(45) Date of publication and mention of the grant of the patent: **18.12.2024**
(21) Application number: 19746761.6
(22) Date of filing: 31.01.2019
(51) Int. Cl.: H04M 1/02, H01R 12/71, H01R 24/50, H05K 1/14

(54) **ELECTRONIC APPARATUS COMPRISING CONNECTOR OF STACKED STRUCTURE**
ELEKTRONISCHE VORRICHTUNG MIT EINEM VERBINDER MIT GESTAPELTER STRUKTUR
APPAREIL ÉLECTRONIQUE COMPRENANT UN CONNECTEUR DE STRUCTURE EMPILÉE

(30) Priority: 31.01.2018 KR 20180011726
(43) Date of publication of application: 21.10.2020
(73) Proprietor: Samsung Electronics Co., Ltd., Gyeonggi-do 16677 (KR)
(72) Inventor: PARK, Junghoon, Suwon-si, Gyeonggi-do 16677 (KR); KIM, Yonghwa, Suwon-si, Gyeonggi-do 16677 (KR); LEE, Hyangbok, Suwon-si, Gyeonggi-do 16677 (KR); SON, Dongil, Suwon-si, Gyeonggi-do 16677 (KR)
(74) Representative: Nederlandsch Octrooibureau
(86) International application number: PCT/KR2019/001349
(87) International publication number: WO 2019/151797

(56) References cited:
- JP-A- 2007 227 180
- JP-A- 2017 010 921
- KR-A- 20120 067 654
- KR-A- 20160 090 549
- KR-B1- 101 231 041
- US-A1- 2015 003 025
- US-A1- 2017 265 322

## Description

### [Technical Field]

Various embodiments of the disclosure described herein relate to a technology for a structural improvement in a connector for connection of a printed circuit board.

### [Background Art]

Recently, with the widespread use of electronic devices having independent operating systems, the electronic devices have evolved into mediums having various functions integrated. Accordingly, electronic parts for supporting functional operations of the electronic devices have been gradually diversified, and to receive a plurality of electronic parts, the electronic devices have solved inner spatial limitations based on an improvement in software or hardware.

KR20120067654A discloses that a printed circuit board connector and an electronic device including thereof are provided to arrange the connector plug by passing the sub printed circuit board(PCB). A printed circuit board connector comprises connector sockets(60,70), a main PCB(10), a connector plug(80), a sub PCB(20), and a through hole(22). The connector sockets are fixed to the main printed circuit. The connector plug(80) is fixed to the sub PCB. The sub PCB is laminated on upper side of the main printed circuit board. The connector plug passes through the through hole(22) of the sub PCB. The connector plug is inserted into the connector socket.

KR101231041B1 discloses that a mobile terminal using a multi-function socket and its method are provided to reduce the size of a mobile terminal by performing a data input/output function and a charging function by using a single socket unit. A connector(190) is connected with an external device and sets an electrical connection. A controller(140) receives or transmits at least one signal through at least one predetermined path according to at least one identification signal by interworking with the connector(190) and a switching unit(160), and generates a control signal for controlling at least one signal. At least one signal is one of a power signal and data.

US2017265322A1 discloses that a connector and an electronic device having the connector are disclosed. The connector includes: a housing formed with an insulator and mounted at a substrate in order to process a digital signal; a pair of sockets that process a Radio Frequency (RF) signal; a pair of terminals formed at a sub PCB in order to process the RF signal; and a signal processor that processes the RF signal and the digital signal. Various embodiments of the present disclosure are possible.

US2015003025A1 discloses that an electronic apparatus includes a frame, a plurality of flexible circuit boards, and a plurality of hardware devices. The frame includes a first frame body and a second frame body. The first frame body and the second frame body are spaced apart from each other, and define an accommodation space therebetween. The flexible circuit boards are accommodated in the accommodation space. Each flexible circuit board includes a first edge and a second edge opposite to the first edge. The first edge is connected to the first frame body. The second edge is connected to the second frame body. The hardware devices are disposed on the corresponding flexible circuit boards.

### [Disclosure]

### [Technical Problem]

Electronic parts received in an electronic device may transmit or receive signals related to performing functions of the corresponding electronic parts, by being electrically connected with a printed circuit board by connectors. Because the plurality of connectors for supporting connection with the electronic parts are mounted on the printed circuit board, a space for mounting another connector or electronic part may be narrow, which may act as an impediment to a structural improvement of the electronic device.

Various embodiments of the disclosure described herein provide a connector having a stack structure for ensuring an available space (e.g., a space in the X-axis or Y-axis direction) on a printed circuit board by implementing at least some of a plurality of connectors mounted on the printed circuit board in a vertical stack (e.g., Z-axis stack) structure, and an electronic device including the same.

### [Technical Solution]

The present invention and technical solution is according to the independent claim Embodiments of the invention are defined in the dependent claims.

### [Advantageous Effects]

According to various embodiments, efficient space design for an electronic part mounted on or connected to a printed circuit board may be achieved based on ensuring an available space on the printed circuit board.

In addition, the disclosure may provide various effects that are directly or indirectly recognized.

### [Description of Drawings]

FIG. 1 is a view illustrating at least some components of an electronic device according to an embodiment.
FIG. 2 is a view illustrating at least a partial area of a printed circuit board according to an embodiment.
FIG. 3 is a view illustrating a first module and a second module according to an embodiment.
FIG. 4 is a view illustrating a stack form of the first module and the second module according to the invention.
FIG. 5 is a view illustrating an application example of a stack structure of a plurality of modules according to an embodiment.
FIG. 6 is a view illustrating a process of transferring a signal to an electronic part according to an embodiment.
FIG. 7 is a view illustrating an electronic device in a network environment according to an embodiment.

### [Mode for Invention]

Hereinafter, various embodiments of the disclosure may be described with reference to accompanying drawings. Accordingly, those of ordinary skill in the art will recognize that modification, equivalent, and/or alternative on the various embodiments described herein can be variously made without departing from the scope of the disclosure. With regard to description of drawings, similar components may be marked by similar reference numerals.

In the disclosure, the expressions "have", "may have", "include" and "comprise", or "may include" and "may comprise" used herein indicate existence of corresponding features (e.g., components such as numeric values, functions, operations, or parts) but do not exclude presence of additional features.

In the disclosure, the expressions "A or B", "at least one of A or/and B", or "one or more of A or/and B", and the like may include any and all combinations of one or more of the associated listed items. For example, the term "A or B", "at least one of A and B", or "at least one of A or B" may refer to all of the case (1) where at least one A is included, the case (2) where at least one B is included, or the case (3) where both of at least one A and at least one B are included.

The terms, such as "first", "second", and the like used in the disclosuremay be used to refer to various components regardless ofthe order and/or the priority and to distinguish the relevant components from other components, but do not limit the components.For example, "a first user device" and "a second user device" indicate different user devices regardless of the order or priority. For example, without departing the scope of the disclosure, a first component may be referred to as a second component, and similarly, a second component may be referred to as a first component.

It will be understood that when an component (e.g., a first component) is referred to as being "(operatively or communicatively) coupled with/to" or "connected to" another component (e.g., a second component), it may be directly coupled with/to or connected to the other component or an intervening component (e.g., a third component) may be present. In contrast, when an component (e.g., a first component) is referred to as being "directly coupled with/to" or "directly connected to" another component (e.g., a second component), it should be understood that there are no intervening component (e.g., a third component).

According to the situation, the expression "configured to" used in the disclosure may be used as, for example, the expression "suitable for", "having the capacity to", "designed to", "adapted to", "made to", or "capable of'. The term "configured to" must not mean only "specifically designed to" in hardware. Instead, the expression "a device configured to" may mean that the device is "capable of" operating together with another device or other parts. For example, a "processor configured to (or set to) perform A, B, and C" may mean a dedicated processor (e.g., an embedded processor) for performing a corresponding operation or a genericpurpose processor (e.g., a central processing unit (CPU) or an application processor) which performs corresponding operations by executing one or more software programs which are stored in a memory device.

Terms used in the disclosure are used to describe specified embodiments and are not intended to limit the scope of the disclosure. The terms of a singular form may include plural forms unless otherwise specified. All the terms used herein, which include technical or scientific terms, may have the same meaning that is generally understood by a person skilled in the art. It will be further understood that terms, which are defined in a dictionary and commonly used, should also be interpreted as is customary in the relevant related art and not in an idealized or overly formal unless expressly so defined in various embodiments of the disclosure. In some cases, even if terms are terms which are defined in the disclosure, they may not be interpreted to exclude embodiments of the disclosure.

An electronic device according to various embodiments of the disclosure may include at least one of, for example, smartphones, tablet personal computers (PCs), mobile phones, video telephones, electronic book readers, desktop PCs, laptop PCs, netbook computers, workstations, servers, personal digital assistants (PDAs), portable multimedia players (PMPs), Motion Picture Experts Group (MPEG-1 or MPEG-2) Audio Layer 3 (MP3) players, mobile medical devices, cameras, or wearable devices. According to various embodiments, the wearable device may include at least one of an accessory type (e.g., watches, rings, bracelets, anklets, necklaces, glasses, contact lens, or head-mounted-devices (HMDs), a fabric or garment-integrated type (e.g., an electronic apparel), a body-attached type (e.g., a skin pad or tattoos), or a bio-implantable type (e.g., an implantable circuit).

According to various embodiments, the electronic device may be a home appliance. The home appliances may include at least one of, for example, televisions (TVs), digital versatile disc (DVD) players, audios, refrigerators, air conditioners, cleaners, ovens, microwave ovens, washing machines, air cleaners, set-top boxes, home automation control panels, security control panels, TV boxes (e.g., Samsung HomeSync^{™}, Apple TV^{™}, or Google TV^{™}), game consoles (e.g., Xbox^{™}or PlayStation^{™}), electronic dictionaries, electronic keys, camcorders, electronic picture frames, and the like.

According to another embodiment, an electronic device may include at least one of various medical devices (e.g., various portable medical measurement devices (e.g., a blood glucose monitoring device, a heartbeat measuring device, a blood pressure measuring device, a body temperature measuring device, and the like), a magnetic resonance angiography (MRA), a magnetic resonance imaging (MRI), a computed tomography (CT), scanners, and ultrasonic devices), navigation devices, Global Navigation Satellite System (GNSS), event data recorders (EDRs), flight data recorders (FDRs), vehicle infotainment devices, electronic equipment for vessels (e.g., navigation systems and gyrocompasses), avionics, security devices, head units for vehicles, industrial or home robots, automated teller machines (ATMs), points of sales (POSs) of stores, or internet of things (e.g., light bulbs, various sensors, electric or gas meters, sprinkler devices, fire alarms, thermostats, street lamps, toasters, exercise equipment, hot water tanks, heaters, boilers, and the like).

According to an embodiment, the electronic device may include at least one of parts of furniture or buildings/structures, electronic boards, electronic signature receiving devices, projectors, or various measuring instruments (e.g., water meters, electricity meters, gas meters, or wave meters, and the like). According to various embodiments, the electronic device may be one of the above-described devices or a combination thereof. An electronic device according to an embodiment may be a flexible electronic device. Furthermore, an electronic device according to an embodiment of the disclosure may not be limited to the above-described electronic devices and may include other electronic devices and new electronic devices according to the development of technologies.

Hereinafter, electronic devices according to various embodiments will be described with reference to the accompanying drawings. In the disclosure, the term "user" may refer to a person who uses an electronic device or may refer to a device (e.g., an artificial intelligence electronic device) that uses the electronic device.

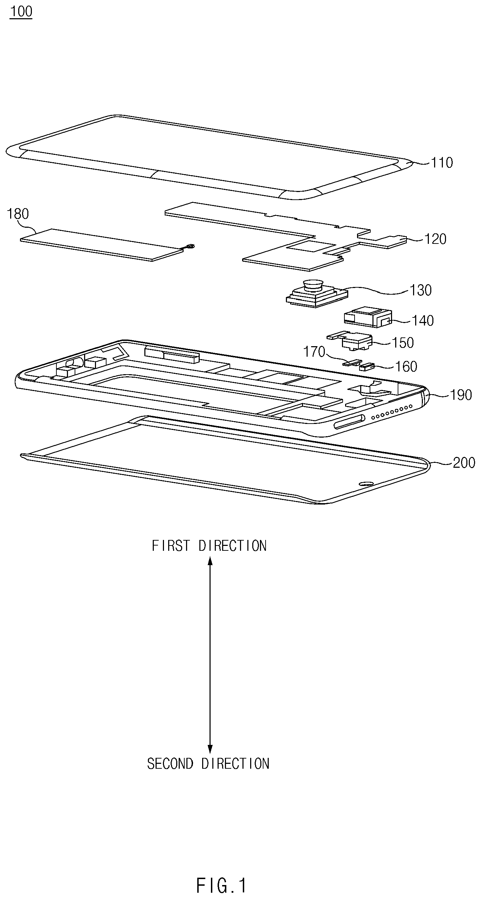

FIG. 1 is a view illustrating some components of an electronic device according to an embodiment.

Referring to FIG. 1, the electronic device 100 may include a rear case 110 (e.g., a rear case), a printed circuit board 120, a first camera module 130 (or, a rear camera module), a receiver module 140 (or, a speaker module), a second camera module 150 (or, a front camera module), a sensor module 160, an LED module 170, a battery 180, a housing 190, and a glass cover 200.

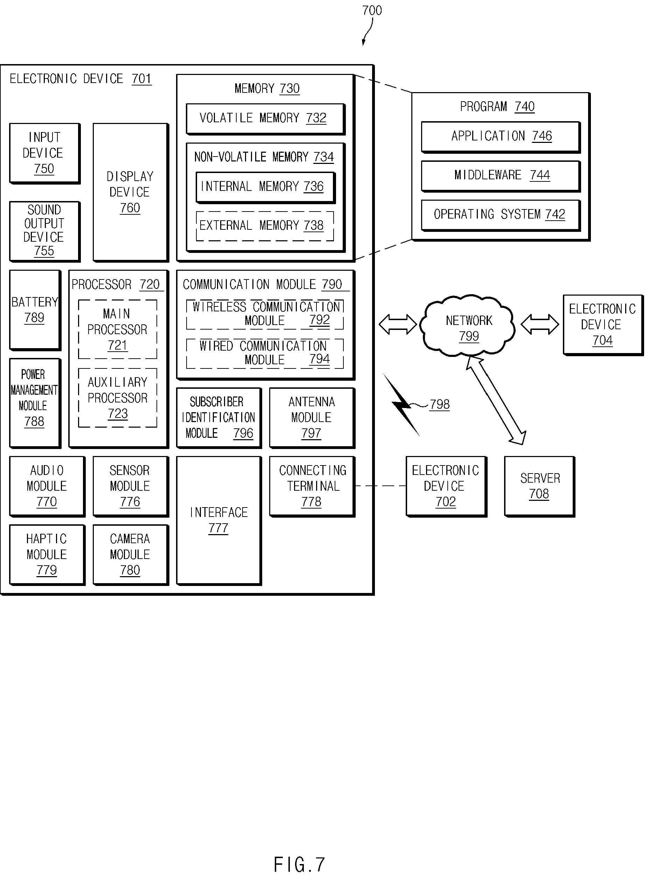

In various embodiments, the electronic device 100 may not include at least one of the aforementioned components, or may additionally include other component(s). For example, the electronic device 100 may further include at least one system resource (e.g., a display, a communication module, a memory, and/or a processor) that supports functional operation of the electronic device 100. The display may output various screens including at least one piece of content. For example, in response to user control or specified scheduling information, the display may output a home screen of the electronic device 100, or may output a screen of an application executed in the electronic device 100. The communication module may support communication between the electronic device 100 and an external device (or, an external server). In this regard, the communication module may establish wired communication or wireless communication with the external device according to a specified protocol and may transmit or receive data, based on the wired communication or the wireless communication. The memory may store at least one piece of data involved in operation of the electronic device 100, or may store at least one command related to functional operations of the components in the electronic device 100. Alternatively, the memory may store at least one application embedded in a preloaded form at the time of manufacturing the electronic device 100 or installed in a third-party form from an online market. The processor may be electrically or operatively connected with the above-described components of the electronic device 100 and may perform control, communication operations, or data processing for the components. In this regard, the processor may be mounted on the printed circuit board 120 and may transmit at least one signal or at least one piece of data related to functional operation of the electronic device 100 to a corresponding component, based on a signal line formed on the printed circuit board 120. In addition, the electronic device 100 may include components of an electronic device (701 of FIG. 7) that will be mentioned with reference to FIG. 7.

At least partial areas of the rear case 110, the housing 190, and the glass cover 200 may be coupled together to form the external appearance of the electronic device 100. In an embodiment, an edge area of the housing 190 may extend in a first direction and a second direction opposite to the first direction by a predetermined length. Accordingly, the housing 190 may include an interior space that is open in the first direction and an interior space that is open in the second direction. In this regard, at least a partial area (e.g., an edge area) of the glass cover 200 may be placed in the interior space of the housing 190 that is open in the second direction and may be coupled with the housing 190, based on, for example, an adhesive member (e.g., a tape). Correspondingly, at least a partial area (e.g., an edge area) of the rear case 110 may be placed in the interior space of the housing 190 that is open in the first direction and may be coupled so as to be detachable later. For example, at least one protruding member may be provided on one area (e.g., an edge area) of one of the rear case 110 or the housing 190, at least one receiving member corresponding to the shape of the protruding member may be provided on at least a partial area (e.g., an edge area) of the other, and the protruding member may be fit into the receiving member in response to external pressure to couple the rear case 110 and the housing 190. In various embodiments, the glass cover 200 is merely the name of a component, and the material of the glass cover 200 is not limited to glass. For example, in relation to implementation of a flexible characteristic of the electronic device 100, the glass cover 200 may contain a flexible transparent film material in at least a partial area thereof. Other components (e.g., the printed circuit board 120, the first camera module 130, the receiver module 140, the second camera module 150, the sensor module 160, the LED module 170, the battery 180, or the system resource) may be received in the interior spaces of the electronic device 100 that are formed by the rear case 110, the housing 190, and the glass cover 200 coupled together as described above.

The first camera module 130 and the second camera module 150 may take an image (a still image or a video) of an area around the electronic device 100 and may be disposed in opposite positions on the electronic device 100 so as to have different angles of view (e.g., the rear or front of the electronic device 100). The receiver module 140 may output a sound by converting a signal generated on the electronic device 100 or received from an external device into vibration. The sensor module 160 may include, for example, a proximity illuminance sensor and may sense at least one object that is adjacent to the electronic device 100 (or, approaches the electronic device 100), or may sense illuminance of an area around the electronic device 100. In various embodiments, the sensor module 160 may further include at least one sensor (e.g., an acceleration sensor, a gyro sensor, a fingerprint sensor, or an iris sensor) for sensing a change in physical quantity acting on the electronic device 100 or performing user authentication, in addition to the proximity illuminance sensor. The LED module 170 may support a flash involved in taking an image when the first camera module 130 or the second camera module 150 operates. Alternatively, the LED module 170 may raise illuminance for an area around the electronic device 100 by operating in response to user control irrespective of operation of the first camera module 130 or the second camera module 150. The battery 180 may be electrically connected with at least one component of the electronic device 100 and may supply power to the at least one component. In various embodiments, the battery 180 may be implemented with a lithium ion battery or a lithium ion polymer battery and may include various types of batteries depending on filling materials, in addition to that.

The printed circuit board 120 may be electrically connected with at least some of the components (e.g., the first camera module 130, the receiver module 140, the second camera module 150, the sensor module 160, the LED module 170, the battery 180, or the system resource) that are received in the interior spaces of the electronic device 100. For example, the printed circuit board 120 may be connected with the components of the electronic device 100, based on at least one signal line formed on at least a partial area of the printed circuit board 120. In this regard, at least one module for supporting electrical connection between a component of the electronic device 100 that is spaced apart from the printed circuit board 120 (or, not mounted on the printed circuit board 120) and the signal line may be mounted on at least a partial area of the printed circuit board 120. According to an embodiment, the module may include a socket and/or a header on at least a partial area, and the aforementioned connector may be understood as a name including the module and the socket. In an embodiment, the module and another module may be vertically stacked on each other based on the socket and/or the header, and the stack structure of the plurality of modules may support multiple connections between the printed circuit board 120 and the components of the electronic device 100. Hereinafter, structural or functional characteristics of a structure in which a plurality of modules are stacked will be described.

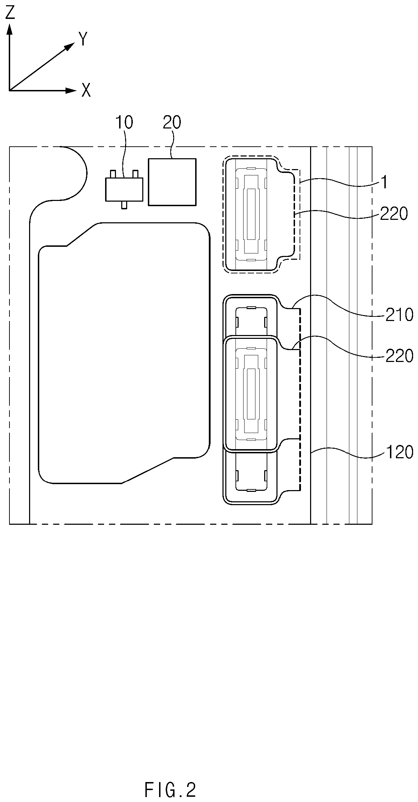

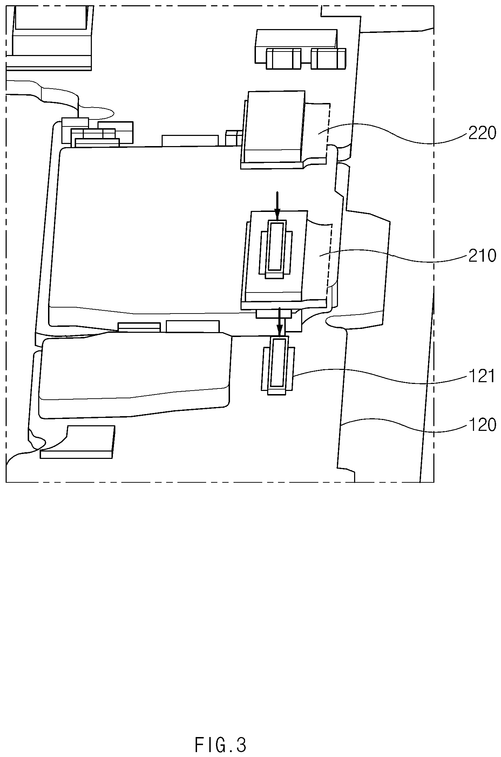

FIG. 2 is a view illustrating at least a partial area of the printed circuit board according to an embodiment, and FIG. 3 is a view illustrating a first module and a second module according to an embodiment.

Referring to FIGS. 2 and 3, the printed circuit board 120 may be formed in a specified size or shape depending on structural or inner spatial design of the electronic device (100 of FIG. 1), and components (or electronic parts) received in the electronic device 100 may be disposed in an area that overlaps at least part of the printed circuit board 120, or may be disposed in an area that avoids the printed circuit board 120 (or, an area spaced apart from the printed circuit board 120). Accordingly, the components of the electronic device 100 may be directly connected with the printed circuit board 120, or may be connected with the printed circuit board 120 through a specified member. For example, at least some components 10 and/or 20 of the electronic device 100 (e.g., components disposed in an area that overlaps at least part of the printed circuit board 120) may be connected with the printed circuit board 120 by being mounted on one area of the printed circuit board 120. Alternatively, at least some other components of the electronic device 100 (e.g., components disposed in an area that avoids the printed circuit board 120 or is spaced apart from the printed circuit board 120) may be electrically connected with the printed circuit board 120 by being mounted on or connected to one area of at least one module mounted on the printed circuit board 120.

In an embodiment, to overcome a limitation of space on the printed circuit board 120, at least a part of the at least one module may be implemented with the aforementioned stack structure of the plurality of modules. For example, a plurality of modules may be mounted on at least a partial area of the printed circuit board 120 in the form of a stack structure in which the plurality of modules are vertically stacked (e.g., stacked in the Z-axis direction) with respect to the printed circuit board 120.

According to an embodiment, the structure in which the plurality of modules are stacked may include the first module 210 including a first socket for connection with a first header 121 mounted on the printed circuit board 120 and the second module 220 including a second socket for connection with a second header included in the first module 210. In other words, the stack structure of the plurality of modules may include the first module 210 mounted on the printed circuit board 120 as a first layer and electrically connected with the printed circuit board 120 and the second module 220 stacked on the top of the first module 210 as a second layer and electrically connected with the first module 210. In various embodiments, the stack structure of the plurality of modules that is received in the electronic device 100 in the form of being mounted on the printed circuit board 120 may further include at least one module stacked on the top of the second module 220, in addition to the first module 210 and the second module 220 as long as the stack structure has a height in a range allowed in the electronic device 100 based on the thickness of the electronic device 100.

According to the above-described stack structure of the plurality of modules, a space (e.g., a space in the X-axis direction or the Y-axis direction) on the printed circuit board 120 may be implemented as a blank. For example, a mounting space (1 of FIG. 2) that one module (e.g., the second connector (220 of FIG. 2)) among the plurality of modules (e.g., the first module 210 and the second module 220) constituting the stack structure occupies when directly mounted on the printed circuit board 120 may be implemented as a blank. Accordingly, the stack structure of the plurality of modules may enable the space 1 implemented as the blank to be used as a mounting space of another component (or electronic part) of the electronic device 100, thereby achieving easy space design in the electronic device 100.

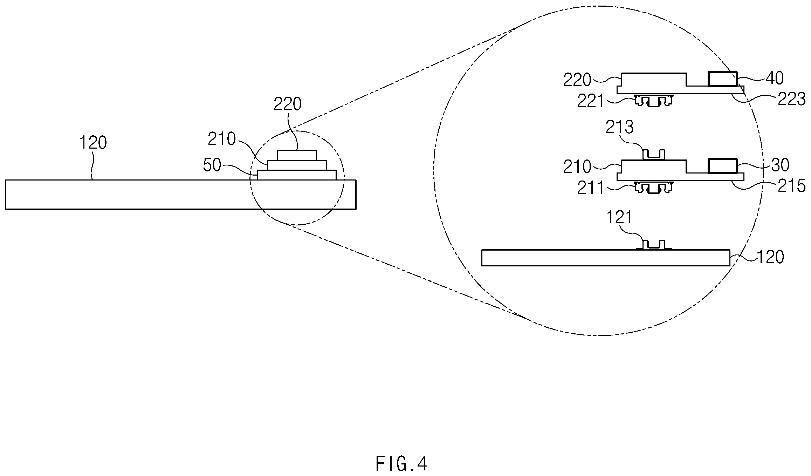

FIG. 4 is a view illustrating a stack form of the first module and the second module according to the invention.

Referring to FIG. 4, the first module 210 and the second module 220 included in the above-described stack structure of the plurality of modules may differ from each other in terms of the shape of at least part, or may include different components, depending on a stack sequence. For example, the first module 210 mounted on the printed circuit board 120 as the first layer may include a shape or a component that is able to be engaged with the printed circuit board 120. Correspondingly the second module 220 stacked on the top of the first module 210 as the second layer may include a shape or a component that is able to be engaged with the first module 210.

In regard to the above description, the printed circuit board 120 includes the first header 121 that supports engagement and electrical connection with the first module 210 mounted on the printed circuit board 120 as the first layer. The first header 121 is electrically connected with at least a part of at least one signal line included in the printed circuit board 120.

The first module 210 includes, on one surface thereof (e.g., a surface facing the printed circuit board 120), a first socket 211 for engagement and electrical connection with the first header 121 on the printed circuit board 120 includes, on an opposite surface thereof, a second header 213 for supporting engagement and electrical connection with the second module 220. The first socket 211 may be implemented in a shape corresponding to the first header 121 of the printed circuit board 120, for example, in a shape that is at least partially fit into the first header 121 or receives at least part of the first header 121. In an embodiment, engagement between the first socket 211 of the first module 210 and the first header 121 of the printed circuit board 120 may mean that an electrical path extending from the printed circuit board 120 to the first module 210 is formed. In various embodiments, a stiffener 50 may be disposed in an area around the engagement of the first socket 211 and the first header 121. The stiffener 50 may support firm engagement between the first socket 211 and the first header 121, or may support a load depending on the first module 210 and/or the second module 220. The second header 213 may be implemented in a shape that is the same as, or similar to, the shape of the first header 121 of the printed circuit board 120.

The second module 220 includes, on one surface thereof (e.g., a surface facing the first module 210), a second socket 221 for engagement with the second header 213 of the first module 210. For example, the second socket 221 may be implemented in a shape that is the same as, or similar to, the shape of the first socket 211 of the first module 210, and when the second socket 221 is engaged with the second header 213 of the first module 210, an electrical path extending from the printed circuit board 120 to the second module 220 via the first module 210 may be formed.

The first header 121 includes a plurality of first conductive terminals. At least some of the plurality of first conductive terminals may pass through at least part of the first module 210 and may extend to the second header 213. Accordingly, an electrical path extending from the printed circuit board 120 to the second module 220 via the first module 210 may be formed.

According to various embodiments, the headers (e.g., the first header 121 and the second header 213) and the sockets (e.g., the first socket 211 and the second socket 221) described above may be implemented in various shapes other than the illustrated shapes as long as the headers and the sockets support engagement and electrical connection between the printed circuit board 120 and the first module 210 or between the first module 210 and the second module 220. Furthermore, when the stack structure of the plurality of modules further includes at least one module in addition to the first module 210 and the second module 220 as described above, the headers and the sockets may be alternately disposed on the plurality of modules included in the stack structure of the plurality of modules.

In an embodiment, the first module 210 may include a first flexible printed circuit board 215 for supporting electrical connection of the first socket 211 and a first electronic part 30 (e.g., an electronic part disposed in an area that avoids the printed circuit board 120 or is spaced apart from the printed circuit board 120). The first flexible printed circuit board 215 may include at least one signal line for transferring a signal or data. For example, one area may be received in the first module 210 and may be electrically connected with the first socket 211, and an opposite area may be exposed outside the first module 210 and may be electrically connected with the first electronic part 30 mounted on the exposed area. According to the above description, a signal or data provided through the printed circuit board 120 of the electronic device 100 may be transferred to the first electronic part 30 via the first header 121 on the printed circuit board 120, the first socket 211 of the first module 210 that is engaged with the first header 121, and the first flexible printed circuit board 215 connected with the first socket 211.

Correspondingly, the second module 220 may include a second flexible printed circuit board 223 for supporting electrical connection of the second socket 221 and a second electronic part 40. Similarly to the first flexible printed circuit board 215, the second flexible printed circuit board 223 may include at least one signal line and may be electrically connected with the second socket 221 and the second electronic part 40. The second electronic part 40 may receive a signal or data from the printed circuit board 120, based on an electrical path constituted by the first header 121 on the printed circuit board 120, the first socket 211 of the first module 210 that is engaged with the first header 121, the second header 213 of the first module 210, the second socket 221 of the second module 220 that is engaged with the second header 213, and the second flexible printed circuit board 223 connected with the second socket 221.

According to an embodiment, the above-described electrical connection between the printed circuit board 120, the first module 210, and the second module 220 may be implemented with at least one terminal (e.g., a pin) that the headers (e.g., the first header 121 and the second header 213) and the sockets (e.g., the first socket 211 and the second socket 221) include. The at least one terminal may enable conduction of electricity between the engaged components to allow a signal or data transmitted from the processor mounted on the printed circuit board 120 to be transferred to the first electronic part 30 included in the first module 210 or the second electronic part 40 included in the second module 220.

The first header 121 on the printed circuit board 120 includes a first terminal subset including at least one terminal (e.g., first to tenth pins) and a second terminal subset including at least one other terminal (e.g., eleventh to twentieth pins). The first socket 211 engaged with the first header 121 includes a third terminal subset constituted by at least one terminal (e.g., first to tenth pins) for physical or electrical connection with the first terminal subset and a fourth terminal subset constituted by at least one terminal (e.g., eleventh to twentieth pins) for physical or electrical connection with the second terminal subset. According to an embodiment, when the first header 121 and the first socket 211 are engaged with each other, the first terminal subset and the third terminal subset may be connected, and therefore electrical connection between the printed circuit board 120 and the first electronic part 30 (or, between the printed circuit board 120 and the first flexible printed circuit board 215 included in the first module 210) may be implemented.

Similarly to the above description, the second header 213 of the first module 210 includes at least one terminal (e.g., first to tenth pins), and the second socket 221 of the second module 220 includes at least one terminal (e.g., first to tenth pins) for physical or electrical connection with the at least one terminal of the second header 213. In this regard, when the first header 121 and the first socket 211 are engaged together and the second header 213 and the second socket 221 are engaged together, the second terminal subset of the first header 121 and the fourth terminal subset of the first socket 211 may be connected together, and the at least one terminal included in the second header 213 and the at least one terminal included in the second socket 221 may be connected together. Accordingly, electrical connection between the printed circuit board 120 and the second electronic part 40 (or, between the printed circuit board 120 and the second flexible printed circuit board 223 included in the second module 220) may be implemented.

In various embodiments, when a third module is stacked on the top of the second module 220, the at least one terminal (e.g., the first to tenth pins) included in the second header 213 and the at least one terminal (e.g., the first to tenth pins) included in the second socket 221 may each be implemented in a terminal subset form. Furthermore, to support electrical connection between the printed circuit board 120 and a third electronic part included in the third module, the second header 213 and the second socket 221 may each further include a terminal subset constituted by at least one terminal (e.g., eleventh to twentieth pins).

The first terminal subset included in the first header 121 on the printed circuit board 120 and the third terminal subset included in the first socket 211 of the first module 210 are connected, and therefore a signal or data transmitted from the processor mounted on the printed circuit board 120 is transferred to the first electronic part through the printed circuit board 120 and the first module 210. Correspondingly, the second terminal subset included in the first header 121 on the printed circuit board 120 and the fourth terminal subset included in the first socket 211 of the first module 210 are connected, and the at least one terminal included in the second header 213 of the first module 210 and the at least one terminal included in the second socket 221 of the second module 220 are connected. Accordingly, a signal or data transmitted from the processor on the printed circuit board 120 is transferred to the second electronic part 40 through the printed circuit board 120, the first module 210, and the second module 220.

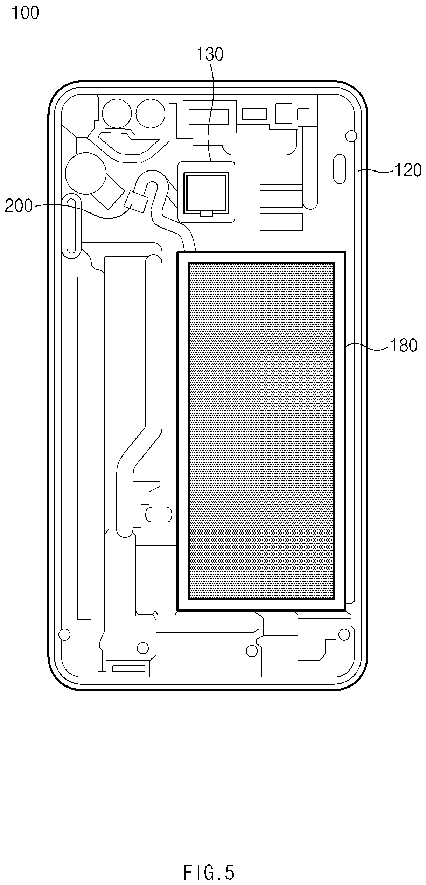

FIG. 5 is a view illustrating an application example of a stack structure of a plurality of modules according to an embodiment.

As described above, the stack structure of the plurality of modules according to the embodiment may support electrical connection between a printed circuit board and an electronic part disposed in an area that avoids the printed circuit board or is spaced apart from the printed circuit board.

For example, referring to FIG. 5, the stack structure 200 of the plurality of modules may support multiple connections between a first electronic part (e.g., the first camera module 130) and a second electronic part (e.g., the battery 180) of the electronic device 100 and the printed circuit board 120, based on the plurality of modules (e.g., the first module 210 and the second module 220 of FIG. 4). According to various embodiments, in multiple connections between the printed circuit board 120 and electronic parts that the stack structure 200 of the plurality of modules supports, a combination of the electronic parts is not limited to that described above (e.g., the first camera module 130 and the battery 180). For example, a combination of the electronic parts may include various combinations in which mutual electrical noise is slight (e.g., the receiver module (140 of FIG. 1) and the battery 180, the sensor module (160 of FIG. 1) and the battery 180, or the LED module (170 of FIG. 1) and the battery 180). Accordingly, the stack structure 200 of the plurality of modules may be disposed on various areas of the printed circuit board 120.

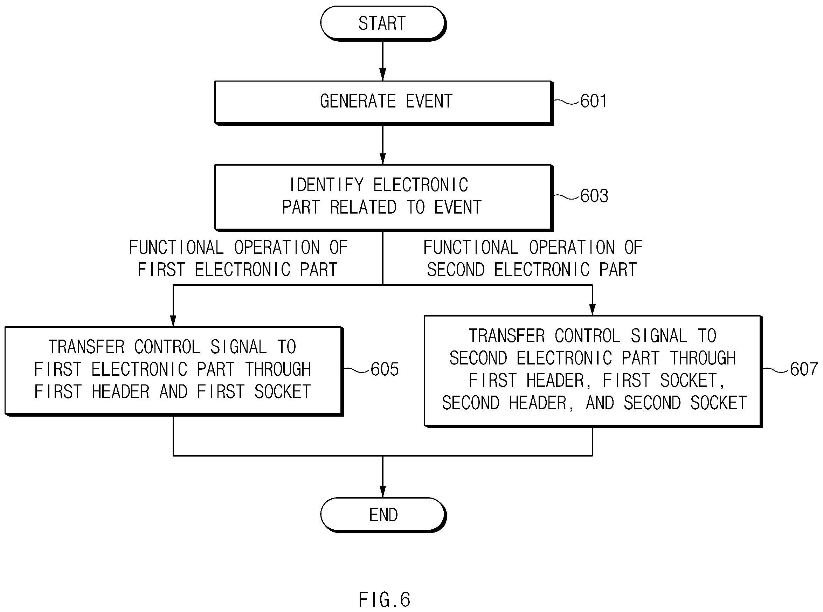

FIG. 6 is a view illustrating a process of transferring a signal to an electronic part according to an embodiment.

Referring to FIG. 6, in operation 601, an event related to operation of a function (e.g., sound output, sensing, or photographing) embedded in the electronic device 100 may be generated on the electronic device (100 of FIG. 1). For example, the processor of the electronic device 100 may receive a user input signal or a specified scheduling signal for operating a component that performs the function.

In operation 603, the processor of the electronic device 100 may identify the component to perform the related function, based on the received signal and may load a command, a signal, or data to be transferred to the corresponding component.

When the component identified in operation 603 is the first electronic part (30 of FIG. 4) included in the first module (210 of FIG. 4) of the stack structure of the plurality of modules according to the embodiment, the command, the signal, or the data may, in operation 605, be transferred to the first electronic part 30 mounted on the first flexible printed circuit board 215, through the signal line of the printed circuit board (120 of FIG. 4) on which the processor is mounted, the first header (121 of FIG. 4) included in the printed circuit board 120 (or, the first terminal subset included in the first header 121), the first socket (211 of FIG. 4) of the first module 210 that is engaged with the first header 121 (or, the third terminal subset included in the first socket 211), and the first flexible printed circuit board (215 of FIG. 4) of the first module 210 that is connected with the first socket 211.

When the component identified in operation 603 is the second electronic part (40 of FIG. 4) included in the second module (220 of FIG. 4) of the stack structure of the plurality of modules, the command, the signal, or the data may, in operation 607, be transferred to the second electronic part 40 mounted on the second flexible printed circuit board 223, through the signal line of the printed circuit board 120, the first header 121 included in the printed circuit board 120 (or, the second terminal subset included in the first header 121), the first socket 211 of the first module 210 that is engaged with the first header 121 (or, the fourth terminal subset included in the first socket 211), the second header (213 of FIG. 4) of the first module 210 (or, the at least one terminal included in the second header 213), the second socket (221 of FIG. 4) of the second module 220 that is engaged with the second header 213 (or, the at least one terminal included in the second socket 221), and the second flexible printed circuit board (223 of FIG. 4) of the second module 220 that is connected with the second socket 221.

An electronic device (e.g., the electronic device 100 of FIG. 1) according to the above-described various embodiments may include a first printed circuit board (e.g., the printed circuit board 120 of FIG. 1) that includes at least one electronic part, a first header (e.g., the first header 121 of FIG. 4) that is mounted on the first printed circuit board, a first module (e.g., the first module 210 of FIG. 4) that includes, on a first surface thereof, a first socket (e.g., the first socket 211 of FIG. 4) for engagement with the first header and includes a second header (e.g., the second header 213 of FIG. 4) on a second surface opposite to the first surface and that performs a first function, a second module (e.g., the second module 220 of FIG. 4) that includes, on one surface thereof, a second socket (e.g., the second socket 221 of FIG. 4) for engagement with the second header and that performs a second function, and a processor (e.g., the processor 720 of FIG. 7) that is electrically connected with the first header.

According to various embodiments, the processor may transfer at least one first signal for control of the first module or at least one second signal for control of the second module to the first header.

According to various embodiments, the first module may further include a first electronic part (e.g., the first electronic part 30 of FIG. 4) that performs the first function, based on the at least one first signal.

According to various embodiments, the first module may further include a second printed circuit board (e.g., the first flexible printed circuit board 215 of FIG. 4) that has at least one signal line that electrically connects the first socket and the first electronic part.

According to various embodiments, the first electronic part may be mounted on at least a partial area of the second printed circuit board.

According to various embodiments, the second module may further include a second electronic part (e.g., the second electronic part 40 of FIG. 4) that performs the second function, based on the at least one second signal.

According to various embodiments, the second module may further include a third printed circuit board (e.g., the second flexible printed circuit board 223 of FIG. 4) that has at least one signal line that electrically connects the second socket and the second electronic part.

According to various embodiments, the second electronic part may be mounted on at least a partial area of the third printed circuit board.

According to various embodiments, the first socket may be formed in a shape corresponding to the first header such that at least a partial of the first socket is fit into the first header or the first socket receives at least a partial area of the first header.

According to various embodiments, the electronic device may further include a stiffener (e.g., the stiffener 50 of FIG. 4) that is disposed in a surrounding area where the first header and the first socket are engaged with each other.

According to various embodiments, the processor may be mounted on at least a partial area of the first printed circuit board.

According to various embodiments, the first printed circuit board may include at least one signal line that electrically connects the processor and the first header.

According to various embodiments, the first module may be mounted on the first printed circuit board, based on engagement of the first header and the first socket.

According to various embodiments, the second module may be vertically stacked on the first module, based on engagement of the second header and the second socket.

An electronic device according to the above-described various embodiments may include a first printed circuit board (e.g., the printed circuit board 120 of FIG. 1), a first header (e.g., the first header 121 of FIG. 4) that is mounted on the first printed circuit board, a first module (e.g., the first module 210 of FIG. 4) that includes, on a first surface thereof, a first socket (e.g., the first socket 211 of FIG. 4) for engagement with the first header, includes a second header (e.g., the second header 213 of FIG. 4) on a second surface opposite to the first surface, and includes a first electronic part (e.g., the first electronic part 30 of FIG. 4) that performs a specified first function, a second module (e.g., the second module 220 of FIG. 4) that includes, on one surface thereof, a second socket (e.g., the second socket 221 of FIG. 4) for engagement with the second header and includes a second electronic part (e.g., the second electronic part 40 of FIG. 4) that performs a specified second function, and a processor (e.g., the processor 720 of FIG. 7) that is electrically connected with the first header.

According to various embodiments, the processor may receive an event signal related to the performance of the first function or the performance of the second function and may identify a related electronic part, based on the event signal.

According to various embodiments, the processor may transfer at least one first control signal related to the performance of the first function to the first electronic part through at least one of the first header or the first socket when an outcome of the identification shows that the event signal is related to the first electronic part.

According to various embodiments, the processor may transfer at least one second control signal related to the performance of the second function to the second electronic part through at least one of the first header, the first socket, the second header, or the second socket when the outcome of the identification shows that the event signal is related to the second electronic part.

According to various embodiments, the first module may be mounted on the first printed circuit board, based on engagement of the first header and the first socket.

According to various embodiments, the second module may be vertically stacked on the first module, based on engagement of the second header and the second socket.

According to various embodiments, the first module may further include a second printed circuit board (e.g., the first flexible printed circuit board 215 of FIG. 4) that has at least one signal line that electrically connects the first socket and the first electronic part.

According to various embodiments, the second module may further include a third printed circuit board (e.g., the second flexible printed circuit board 223 of FIG. 4) that has at least one signal line that electrically connects the second socket and the second electronic part.

According to the invention, the first header may include a first plurality of terminals, and the first socket may include a second plurality of terminals electrically connected with the first plurality of terminals.

According to various embodiments, the processor may be electrically connected with the first electronic part, based on the first plurality of terminals and the second plurality of terminals when the first header and the first socket are engaged with each other.

According to the invention, the second header may include a third plurality of terminals, and the second socket may include a fourth plurality of terminals electrically connected with the third plurality of terminals.

According to various embodiments, the processor may be electrically connected with the second electronic part, based on the first plurality of terminals, the second plurality of terminals, the third plurality of terminals, and the fourth plurality of terminals when the first header and the first socket are engaged together and the second header and the second socket are engaged together.

According to various embodiments, the first module may be mounted on the first printed circuit board, based on engagement of the first header and the first socket.

According to various embodiments, the second module may be vertically stacked on the first module, based on engagement of the second header and the second socket.

According to the invention, the first plurality of terminals includes a first terminal subset including at least one terminal among the first plurality of terminals and a second terminal subset including at least one terminal other than the first terminal subset among the first plurality of terminals.

According the invention, the second plurality of terminals includes a third terminal subset that includes at least one terminal among the second plurality of terminals and that is electrically connected with the first terminal subset and a fourth terminal subset that includes at least one terminal other than the third terminal subset among the second plurality of terminals and that is electrically connected with the second terminal subset.

According to various embodiments, the processor may be electrically connected with the first electronic part, based on the first terminal subset and the third terminal subset when the first header and the first socket are engaged with each other.

According to various embodiments, the third plurality of terminals may include a fifth terminal subset including at least one terminal among the third plurality of terminals.

According to various embodiments, the fourth plurality of terminals may include a sixth terminal subset that includes at least one terminal among the fourth plurality of terminals and that is electrically connected with the fifth terminal subset.

According to various embodiments, the processor may be electrically connected with the second electronic part, based on the second terminal subset, the fourth terminal subset, the fifth subset, and the sixth subset when the first header and the first socket are engaged together and the second header and the second socket are engaged together.

FIG. 7 is a block diagram of an electronic device in a network environment according to various embodiments.

Referring to FIG. 7, an electronic device 701 may communicate with an electronic device 702 through a first network 798 (e.g., a short-range wireless communication) or may communicate with an electronic device 704 or a server 708 through a second network 799 (e.g., a long-distance wireless communication) in a network environment 700. According to an embodiment, the electronic device 701 may communicate with the electronic device 704 through the server 708. According to an embodiment, the electronic device 701 may include a processor 720, a memory 730, an input device 750, a sound output device 755, a display device 760, an audio module 770, a sensor module 776, an interface 777, a haptic module 779, a camera module 780, a power management module 788, a battery 789, a communication module 790, a subscriber identification module 796, and an antenna module 797. According to some embodiments, at least one (e.g., the display device 760 or the camera module 780) among components of the electronic device 701 may be omitted or other components may be added to the electronic device 701. According to some embodiments, some components may be integrated and implemented as in the case of the sensor module 776 (e.g., a fingerprint sensor, an iris sensor, or an illuminance sensor) embedded in the display device 760 (e.g., a display).

The processor 720 may operate, for example, software (e.g., a program 740) to control at least one of other components (e.g., a hardware or software component) of the electronic device 701 connected to the processor 720 and may process and compute a variety of data. The processor 720 may load a command set or data, which is received from other components (e.g., the sensor module 776 or the communication module 790), into a volatile memory 732, may process the loaded command or data, and may store result data into a nonvolatile memory 734. According to an embodiment, the processor 720 may include a main processor 721 (e.g., a central processing unit or an application processor) and an auxiliary processor 723 (e.g., a graphic processing device, an image signal processor, a sensor hub processor, or a communication processor), which operates independently from the main processor 721, additionally or alternatively uses less power than the main processor 721, or is specified to a designated function. In this case, the auxiliary processor 723 may operate separately from the main processor 721 or embedded.

In this case, the auxiliary processor 723 may control, for example, at least some of functions or states associated with at least one component (e.g., the display device 760, the sensor module 776, or the communication module 790) among the components of the electronic device 701 instead of the main processor 721 while the main processor 721 is in an inactive (e.g., sleep) state or together with the main processor 721 while the main processor 721 is in an active (e.g., an application execution) state. According to an embodiment, the auxiliary processor 723 (e.g., the image signal processor or the communication processor) may be implemented as a part of another component (e.g., the camera module 780 or the communication module 790) that is functionally related to the auxiliary processor 723. The memory 730 may store a variety of data used by at least one component (e.g., the processor 720 or the sensor module 776) of the electronic device 701, for example, software (e.g., the program 740) and input data or output data with respect to commands associated with the software. The memory 730 may include the volatile memory 732 or the nonvolatile memory 734.

The program 740 may be stored in the memory 730 as software and may include, for example, an operating system 742, a middleware 744, or an application 746.

The input device 750 may be a device for receiving a command or data, which is used for a component (e.g., the processor 720) of the electronic device 701, from an outside (e.g., a user) of the electronic device 701 and may include, for example, a microphone, a mouse, or a keyboard.

The sound output device 755 may be a device for outputting a sound signal to the outside of the electronic device 701 and may include, for example, a speaker used for general purposes, such as multimedia play or recordings play, and a receiver used only for receiving calls. According to an embodiment, the receiver and the speaker may be either integrally or separately implemented.

The display device 760 may be a device for visually presenting information to the user of the electronic device 701 and may include, for example, a display, a hologram device, or a projector and a control circuit for controlling a corresponding device. According to an embodiment, the display device 760 may include a touch circuitry or a pressure sensor for measuring an intensity of pressure on the touch.

The audio module 770 may convert a sound and an electrical signal in dual directions. According to an embodiment, the audio module 770 may obtain the sound through the input device 750 or may output the sound through an external electronic device (e.g., the electronic device 702 (e.g., a speaker or a headphone)) wired or wirelessly connected to the sound output device 755 or the electronic device 701.

The sensor module 776 may generate an electrical signal or a data value corresponding to an operating state (e.g., power or temperature) inside or an environmental state outside the electronic device 701. The sensor module 776 may include, for example, a gesture sensor, a gyro sensor, a barometric pressure sensor, a magnetic sensor, an acceleration sensor, a grip sensor, a proximity sensor, a color sensor, an infrared sensor, a biometric sensor, a temperature sensor, a humidity sensor, or an illuminance sensor.

The interface 777 may support a designated protocol wired or wirelessly connected to the external electronic device (e.g., the electronic device 702). According to an embodiment, the interface 777 may include, for example, an HDMI (high-definition multimedia interface), a USB (universal serial bus) interface, an SD card interface, or an audio interface.

A connecting terminal 778 may include a connector that physically connects the electronic device 701 to the external electronic device (e.g., the electronic device 702), for example, an HDMI connector, a USB connector, an SD card connector, or an audio connector (e.g., a headphone connector).

The haptic module 779 may convert an electrical signal to a mechanical stimulation (e.g., vibration or movement) or an electrical stimulation perceived by the user through tactile or kinesthetic sensations. The haptic module 779 may include, for example, a motor, a piezoelectric element, or an electric stimulator.

The camera module 780 may shoot a still image or a video image. According to an embodiment, the camera module 780 may include, for example, at least one lens, an image sensor, an image signal processor, or a flash.

The power management module 788 may be a module for managing power supplied to the electronic device 701 and may serve as at least a part of a power management integrated circuit (PMIC).

The battery 789 may be a device for supplying power to at least one component of the electronic device 701 and may include, for example, a nonrechargeable (primary) battery, a rechargeable (secondary) battery, or a fuel cell.

The communication module 790 may establish a wired or wireless communication channel between the electronic device 701 and the external electronic device (e.g., the electronic device 702, the electronic device 704, or the server 708) and support communication execution through the established communication channel. The communication module 790 may include at least one communication processor operating independently from the processor 720 (e.g., the application processor) and supporting the wired communication or the wireless communication. According to an embodiment, the communication module 790 may include a wireless communication module 792 (e.g., a cellular communication module, a short-range wireless communication module, or a GNSS (global navigation satellite system) communication module) or a wired communication module 794 (e.g., an LAN (local area network) communication module or a power line communication module) and may communicate with the external electronic device using a corresponding communication module among them through the first network 798 (e.g., the short-range communication network such as a Bluetooth, a WiFi direct, or an IrDA (infrared data association)) or the second network 799 (e.g., the long-distance wireless communication network such as a cellular network, an internet, or a computer network (e.g., LAN or WAN)). The above-mentioned various communication modules 790 may be implemented into one chip or into separate chips, respectively.

According to an embodiment, the wireless communication module 792 may identify and authenticate the electronic device 701 using user information stored in the subscriber identification module 796 in the communication network.

The antenna module 797 may include one or more antennas to transmit or receive the signal or power to or from an external source. According to an embodiment, the communication module 790 (e.g., the wireless communication module 792) may transmit or receive the signal to or from the external electronic device through the antenna suitable for the communication method.

Some components among the components may be connected to each other through a communication method (e.g., a bus, a GPIO (general purpose input/output), an SPI (serial peripheral interface), or an MIPI (mobile industry processor interface)) used between peripheral devices to exchange signals (e.g., a command or data) with each other.

According to an embodiment, the command or data may be transmitted or received between the electronic device 701 and the external electronic device 704 through the server 708 connected to the second network 799. Each of the electronic devices 702 and 704 may be the same or different types as or from the electronic device 701. According to an embodiment, all or some of the operations performed by the electronic device 701 may be performed by another electronic device or a plurality of external electronic devices. When the electronic device 701 performs some functions or services automatically or by request, the electronic device 701 may request the external electronic device to perform at least some of the functions related to the functions or services, in addition to or instead of performing the functions or services by itself. The external electronic device receiving the request may carry out the requested function or the additional function and transmit the result to the electronic device 701. The electronic device 701 may provide the requested functions or services based on the received result as is or after additionally processing the received result. To this end, for example, a cloud computing, distributed computing, or client-server computing technology may be used.

The electronic device according to various embodiments disclosed in the disclosure may be various types of devices. The electronic device may include, for example, at least one of a portable communication device (e.g., a smartphone), a computer device, a portable multimedia device, a mobile medical appliance, a camera, a wearable device, or a home appliance. The electronic device according to an embodiment of the disclosure should not be limited to the above-mentioned devices.

It should be understood that various embodiments of the disclosure and terms used in the embodiments do not intend to limit technologies disclosed in the disclosure to the particular forms disclosed herein; rather, the disclosure should be construed to cover various modifications, equivalents, and/or alternatives of embodiments of the disclosure. With regard to description of drawings, similar components may be assigned with similar reference numerals. As used herein, singular forms may include plural forms as well unless the context clearly indicates otherwise. In the disclosure disclosed herein, the expressions "A or B", "at least one of A or/and B", "A, B, or C" or "one or more of A, B, or/and C", and the like used herein may include any and all combinations of one or more of the associated listed items. The expressions "a first", "a second", "the first", or "the second", used in herein, may refer to various components regardless of the order and/or the importance, but do not limit the corresponding components. The above expressions are used merely for the purpose of distinguishing a component from the other components. It should be understood that when a component (e.g., a first component) is referred to as being (operatively or communicatively) "connected," or "coupled," to another component (e.g., a second component), it may be directly connected or coupled directly to the other component or any other component (e.g., a third component) may be interposed between them.

The term "module" used herein may represent, for example, a unit including one or more combinations of hardware, software and firmware. The term "module" may be interchangeably used with the terms "logic", "logical block", "part" and "circuit". The "module" may be a minimum unit of an integrated part or may be a part thereof. The "module" may be a minimum unit for performing one or more functions or a part thereof. For example, the "module" may include an application-specific integrated circuit (ASIC).

Various embodiments of the disclosure may be implemented by software (e.g., the program 740) including an instruction stored in a machine-readable storage media (e.g., an internal memory 736 or an external memory 738) readable by a machine (e.g., a computer). The machine may be a device that calls the instruction from the machine-readable storage media and operates depending on the called instruction and may include the electronic device (e.g., the electronic device 701). When the instruction is executed by the processor (e.g., the processor 720), the processor may perform a function corresponding to the instruction directly or using other components under the control of the processor. The instruction may include a code generated or executed by a compiler or an interpreter. The machine-readable storage media may be provided in the form of non-transitory storage media. Here, the term "non-transitory", as used herein, is a limitation of the medium itself (i.e., tangible, not a signal) as opposed to a limitation on data storage persistency.

According to an embodiment, the method according to various embodiments disclosed in the disclosure may be provided as a part of a computer program product. The computer program product may be traded between a seller and a buyer as a product. The computer program product may be distributed in the form of machine-readable storage medium (e.g., a compact disc read only memory (CD-ROM)) or may be distributed only through an application store (e.g., a Play Store^{™}). In the case of online distribution, at least a portion of the computer program product may be temporarily stored or generated in a storage medium such as a memory of a manufacturer's server, an application store's server, or a relay server.

Each component (e.g., the module or the program) according to various embodiments may include at least one of the above components, and a portion of the above sub-components may be omitted, or additional other sub-components may be further included. Alternatively or additionally, some components (e.g., the module or the program) may be integrated in one component and may perform the same or similar functions performed by each corresponding components prior to the integration. Operations performed by a module, a programming, or other components according to various embodiments of the disclosure may be executed sequentially, in parallel, repeatedly, or in a heuristic method. Also, at least some operations may be executed in different sequences, omitted, or other operations may be added.

While the disclosure has been shown and described with reference to various embodiments thereof, it will be understood by those skilled in the art that various changes in form and details may be made therein without departing from the scope of the disclosure as defined by the appended claims.

## Claims

1. An electronic device (702) comprising:
a first printed circuit board (120) including at least one electronic part;
a first header (121) mounted on the first printed circuit board (120);
a first module (210) including, on a first surface thereof, a first socket (211) for engagement with the first header (121) and including a second header (213) on a second surface opposite to the first surface, the first module (210) being configured to perform a first function;
a second module (220) including, on one surface thereof, a second socket (221) for engagement with the second header (213), the second module (220) being configured to perform a second function; and
a processor (720) electrically connected with the first header (121),
wherein the processor (720) is configured to transfer at least one first signal for control of the first module (210) or at least one second signal for control of the second module (220) to the first header (121),
wherein the first header (121) includes a first plurality of terminals, and the first socket (211) includes a second plurality of terminals electrically connected with the first plurality of terminals,
wherein the second header (213) includes a third plurality of terminals, and the second socket (221) includes a fourth plurality of terminals electrically connected with the third plurality of terminals,
wherein the first plurality of terminals includes a first terminal subset and a second terminal subset, and the second plurality of terminals includes a third terminal subset electrically connected with the first terminal subset and a fourth terminal subset electrically connected with the second terminal subset,
wherein the first terminal subset and the third terminal subset are configured to transfer the at least one first signal from the first header (121) to the first module (210), and
wherein the second terminal subset, the fourth terminal subset, at least one of the third plurality of terminals, and at least one of the fourth plurality of terminals that electrically connected with the at least one of the third plurality of terminals are configured to transfer the at least one second signal the first header (121) to the second module (220).

2. The electronic device of claim 1, wherein the first module (210) further includes a first electronic part (30) configured to perform the first function, based on the at least one first signal.

3. The electronic device of claim 2, wherein the first module (210) further includes a second printed circuit board (215) having at least one signal line configured to electrically connect the first socket (211) and the first electronic part (30).

4. The electronic device of claim 3, wherein the first electronic part (30) is mounted on at least a partial area of the second printed circuit board (215).

5. The electronic device of claim 1, wherein the second module (220) further includes a second electronic part (40) configured to perform the second function, based on the at least one second signal.

6. The electronic device of claim 5, wherein the second module (220) further includes a third printed circuit board (223) having at least one signal line configured to electrically connect the second socket (221) and the second electronic part (40).

7. The electronic device of claim 6, wherein the second electronic part (40) is mounted on at least a partial area of the third printed circuit board (223).

8. The electronic device of claim 1, wherein the first socket (211) is formed in a shape corresponding to the first header (121) such that at least a partial of the first socket (211) is fit into the first header (121) or the first socket (211) receives at least a partial area of the first header (121).

9. The electronic device of claim 1, wherein the processor (720) is mounted on at least a partial area of the first printed circuit board (120), and
wherein the first printed circuit board (120) includes at least one signal line configured to electrically connect the processor (720) and the first header (121).

10. The electronic device of claim 1, wherein the first module (210) is mounted on the first printed circuit board (120), based on engagement of the first header (121) and the first socket (211), and
wherein the second module (220) is vertically stacked on the first module (210), based on engagement of the second header (213) and the second socket (221).

11. The electronic device of claim 1, wherein the first module (210) further includes a first electronic part (30) configured to perform the first function,
wherein the second module (220) further includes a second electronic part (40) configured to perform the second function, and
wherein the processor (720) is further configured to:
receive an event signal related to a performance of the first function or a performance of the second function;
identify a related electronic part, based on the event signal;
transfer at least one first control signal related to the performance of the first function to the first electronic part (30) through at least one of the first header (121) or the first socket (211) when an outcome of the identification shows that the event signal is related to the first electronic part (30); and
transfer at least one second control signal related to the performance of the second function to the second electronic part (40) through at least one of the first header (121), the first socket (211), the second header (213), or the second socket (221) when the outcome of the identification shows that the event signal is related to the second electronic part (40).

12. The electronic device of claim 11, wherein the first module (210) is mounted on the first printed circuit board (120), based on engagement of the first header (121) and the first socket (221), and
wherein the second module (220) is vertically stacked on the first module (210), based on engagement of the second header (213) and the second socket (221).

13. The electronic device of claim 11, wherein the first module (210) further includes a second printed circuit board (215) having at least one signal line configured to electrically connect the first socket (211) and the first electronic part (30).

14. The electronic device of claim 11, wherein the second module (220) further includes a third printed circuit board (223) having at least one signal line configured to electrically connect the second socket (221) and the second electronic part (40).

15. The electronic device of claim 1, wherein the plurality of third terminals disposed in the first socket (211), and
wherein at least some of the plurality of first terminals extend through the first socket (211) so as to be electrically connected with the third terminals.

## Patentansprüche

1. Elektronische Vorrichtung (702), die Folgendes umfasst:
eine erste Leiterplatte (120), die mindestens ein elektronisches Teil enthält;
einen ersten Header (121), der auf der ersten Leiterplatte (120) montiert ist;
ein erstes Modul (210), das auf einer ersten Oberfläche desselben eine erste Buchse (211) zum Eingriff mit dem ersten Header (121) enthält und einen zweiten Header (213) auf einer zweiten Oberfläche gegenüber der ersten Oberfläche enthält, wobei das erste Modul (210) zum Ausführen einer ersten Funktion konfiguriert ist;
ein zweites Modul (220), das auf einer Oberfläche desselben eine zweite Buchse (221) zum Eingriff mit dem zweiten Header (213) enthält, wobei das zweite Modul (220) zum Ausführen einer zweiten Funktion konfiguriert ist; und
einen Prozessor (720), der mit dem ersten Header (121) elektrisch verbunden ist,
wobei der Prozessor (720) so konfiguriert ist, dass er mindestens ein erstes Signal zur Steuerung des ersten Moduls (210) oder mindestens ein zweites Signal zur Steuerung des zweiten Moduls (220) an den ersten Header (121) überträgt,
wobei der erste Header (121) eine erste Vielzahl von Anschlüssen enthält und die erste Buchse (211) eine zweite Vielzahl von Anschlüssen enthält, die mit der ersten Vielzahl von Anschlüssen elektrisch verbunden sind,
wobei der zweite Header (213) eine dritte Vielzahl von Anschlüssen enthält und die zweite Buchse (211) eine vierte Vielzahl von Anschlüssen enthält, die mit der dritten Vielzahl von Anschlüssen elektrisch verbunden sind,
wobei die erste Vielzahl von Anschlüssen einen ersten Anschlussteilsatz und einen zweiten Anschlussteilsatz enthalten und die zweite Vielzahl von Anschlüssen einen dritten Anschlussteilsatz, der mit dem ersten Anschlussteilsatz elektrisch verbunden ist, und einen vierten Anschlussteilsatz enthalten, der mit dem zweiten Anschlussteilsatz elektrisch verbunden ist.
wobei der erste Anschlussteilsatz und der dritte Anschlussteilsatz so konfiguriert sind, dass sie das mindestens eine erste Signal von dem ersten Header (121) an das erste Modul (210) übertragen, und
wobei der zweite Anschlussteilsatz, der vierte Anschlussteilsatz, mindestens einer der dritten Vielzahl von Anschlüssen und mindestens einer der vierten Vielzahl von Anschlüssen, die mit dem mindestens einen der dritten Vielzahl von Anschlüssen elektrisch verbunden sind, so konfiguriert sind, dass sie das mindestens eine zweite Signal von dem ersten Header (121) an das zweite Modul (220) übertragen.

2. Elektronische Vorrichtung nach Anspruch 1, wobei das erste Modul (210) ferner ein erstes elektronisches Teil (30) enthält, das zum Ausführen der ersten Funktion konfiguriert ist, basierend auf dem mindestens einen ersten Signal.

3. Elektronische Vorrichtung nach Anspruch 2, wobei das erste Modul (210) ferner eine zweite Leiterplatte (215) mit mindestens einer Signalleitung enthält, die so konfiguriert ist, dass sie die erste Buchse (211) und das erste elektronische Teil (30) elektrisch verbindet.

4. Elektronische Vorrichtung nach Anspruch 3, wobei das erste elektronische Teil (30) auf mindestens einem Teilbereich der zweiten Leiterplatte (215) montiert ist.

5. Elektronische Vorrichtung nach Anspruch 1, wobei das zweite Modul (220) ferner ein zweites elektronisches Teil (40) enthält, das zum Ausführen der zweiten Funktion konfiguriert ist, basierend auf dem mindestens einen zweiten Signal.

6. Elektronische Vorrichtung nach Anspruch 5, wobei das zweite Modul (220) ferner eine dritte Leiterplatte (223) mit mindestens einer Signalleitung enthält, die so konfiguriert ist, dass sie die zweite Buchse (221) und das zweite elektronische Teil (40) elektrisch verbindet.

7. Elektronische Vorrichtung nach Anspruch 6, wobei das zweite elektronische Teil (40) auf mindestens einem Teilbereich der dritten Leiterplatte (223) montiert ist.

8. Elektronische Vorrichtung nach Anspruch 1, wobei die erste Buchse (211) in einer Form gebildet ist, die dem ersten Header (121) entspricht, so dass mindestens ein Teil der ersten Buchse (211) in den ersten Header (121) passt oder die erste Buchse (211) mindestens einen Teilbereich des ersten Headers (121) aufnimmt.

9. Elektronische Vorrichtung nach Anspruch 1, wobei der Prozessor (720) auf mindestens einem Teilbereich der ersten Leiterplatte (120) montiert ist, und
wobei die erste Leiterplatte (120) mindestens eine Signalleitung enthält, die so konfiguriert ist, dass sie den Prozessor (720) und den ersten Header (121) elektrisch verbindet.

10. Elektronische Vorrichtung nach Anspruch 1, wobei das erste Modul (210) auf der ersten Leiterplatte (120) montiert ist, basierend auf dem Eingriff des ersten Headers (121) und der ersten Buchse (211), und
wobei das zweite Modul (220) senkrecht auf dem ersten Modul (210) gestapelt ist, basierend auf dem Eingriff des zweiten Headers (213) und der zweiten Buchse (221).

11. Elektronische Vorrichtung nach Anspruch 1, wobei das erste Modul (210) ferner ein erstes elektronisches Teil (30) enthält, das zum Ausführen der ersten Funktion konfiguriert ist,
wobei das zweite Modul (220) ferner ein zweites elektronisches Teil (40) enthält, das zum Ausführen der zweiten Funktion konfiguriert ist, und
wobei der Prozessor (720) ferner zu Folgendem konfiguriert ist:
Empfangen eines Ereignissignals in Bezug auf eine Ausführung der ersten Funktion oder eine Ausführung der zweiten Funktion;
Identifizieren eines zugehörigen elektronischen Teils basierend auf dem Ereignissignal;
Übertragen von mindestens einem ersten Steuersignal in Bezug auf die Ausführung der ersten Funktion an das erste elektronische Teil (30) über den ersten Header (121) und/oder die erste Buchse (211), wenn ein Ergebnis der Identifizierung zeigt, dass sich das Ereignissignal auf das erste elektronische Teil (30) bezieht; und
Übertragen von mindestens einem zweiten Steuersignal in Bezug auf die Ausführung der zweiten Funktion an das zweite elektronische Teil (40) über den ersten Header (121), die erste Buchse (211), den zweiten Header (213) und/oder die zweite Buchse (221), wenn das Ergebnis der Identifizierung zeigt, dass sich das Ereignissignal auf das zweite elektronische Teil (40) bezieht.

12. Elektronische Vorrichtung nach Anspruch 11, wobei das erste Modul (210) auf der ersten Leiterplatte (120) montiert ist, basierend auf dem Eingriff des ersten Headers (121) und der ersten Buchse (221), und
wobei das zweite Modul (220) senkrecht auf dem ersten Modul (210) gestapelt ist, basierend auf dem Eingriff des zweiten Headers (213) und der zweiten Buchse (221).

13. Elektronische Vorrichtung nach Anspruch 11, wobei das erste Modul (210) ferner eine zweite Leiterplatte (215) mit mindestens einer Signalleitung enthält, die so konfiguriert ist, dass sie die erste Buchse (211) und das erste elektronische Teil (30) elektrisch verbindet.

14. Elektronische Vorrichtung nach Anspruch 11, wobei das zweite Modul (220) ferner eine dritte Leiterplatte (223) mit mindestens einer Signalleitung enthält, die so konfiguriert ist, dass sie die zweite Buchse (221) und das zweite elektronische Teil (40) elektrisch verbindet.

15. Elektronische Vorrichtung nach Anspruch 1, wobei die Vielzahl von dritten Anschlüssen in der ersten Buchse (211) angeordnet sind, und
wobei sich mindestens einige der Vielzahl von ersten Anschlüssen durch die erste Buchse (211) erstrecken, um mit den dritten Anschlüssen elektrisch verbunden zu sein.

## Revendications

1. Dispositif électronique (702) comprenant :
une première carte de circuit imprimé (120) incluant au moins une partie électronique ;
un premier en-tête (121) monté sur la première carte de circuit imprimé (120) ;
un premier module (210), incluant, sur une première surface de celui-ci, une première prise (211) pour un engagement avec le premier en-tête (121) et incluant un deuxième en-tête (213) sur une deuxième surface opposée à la première surface, le premier module (210) étant configuré pour effectuer une première fonction ;
un deuxième module (220), incluant, sur une surface de celui-ci, une deuxième prise (221) pour un engagement avec le deuxième en-tête (213), le deuxième module (220) étant configuré pour effectuer une deuxième fonction ; et
un processeur (720) connecté électriquement au premier en-tête (121),
où le processeur (720) est configuré pour transférer au moins un premier signal de commande du premier module (210) ou au moins un deuxième signal de commande du deuxième module (220) au premier en-tête (121),
où le premier en-tête (121) inclut une première pluralité de bornes, et la première prise (211) inclut une deuxième pluralité de bornes connectées électriquement à la première pluralité de bornes,
où le deuxième en-tête (213) inclut une troisième pluralité de bornes, et la deuxième prise (221) inclut une quatrième pluralité de bornes connectées électriquement à la troisième pluralité de bornes,
où la première pluralité de bornes inclut un premier sous-ensemble de bornes et un deuxième sous-ensemble de bornes, et la deuxième pluralité de bornes inclut un troisième sous-ensemble de bornes connecté électriquement au premier sous-ensemble de bornes et un quatrième sous-ensemble de bornes connecté électriquement au deuxième sous-ensemble de bornes.
où le premier sous-ensemble de bornes et le troisième sous-ensemble de bornes sont configurés pour transférer l'au moins un premier signal du premier en-tête (121) au premier module (210), et
où le deuxième sous-ensemble de bornes, le quatrième sous-ensemble de bornes, au moins un de la troisième pluralité de bornes, et au moins un de la quatrième pluralité de bornes qui sont connectés électriquement à l'au moins un de la troisième pluralité de bornes sont configurés pour transférer l'au moins un deuxième signal du premier en-tête (121) au deuxième module (220).

2. Dispositif électronique selon la revendication 1, où le premier module (210) inclut en outre une première partie électronique (30) configurée pour effectuer la première fonction, sur la base de l'au moins un premier signal.

3. Dispositif électronique selon la revendication 2, où le premier module (210) inclut en outre une deuxième carte de circuit imprimé (215) ayant au moins une ligne de signal configurée pour connecter électriquement la première prise (211) et la première partie électronique (30).

4. Dispositif électronique selon la revendication 3, où la première partie électronique (30) est montée sur au moins une zone partielle de la deuxième carte de circuit imprimé (215).

5. Dispositif électronique selon la revendication 1, où le deuxième module (220) inclut en outre une deuxième partie électronique (40) configurée pour effectuer la deuxième fonction, sur la base de l'au moins un deuxième signal.

6. Dispositif électronique selon la revendication 5, où le deuxième module (220) inclut en outre une troisième carte de circuit imprimé (223) ayant au moins une ligne de signal configurée pour connecter électriquement la deuxième prise (221) et la deuxième partie électronique (40).

7. Dispositif électronique selon la revendication 6, où la deuxième partie électronique (40) est montée sur au moins une zone partielle de la troisième carte de circuit imprimé (223).

8. Dispositif électronique selon la revendication 1, où la première prise (211) est formée dans une forme correspondant au premier en-tête (121) de sorte qu'au moins un partiel de la première prise (211) est inséré dans le premier en-tête (121) ou la première prise (211) reçoit au moins une zone partielle du premier en-tête (121).

9. Dispositif électronique selon la revendication 1, où le processeur (720) est monté sur au moins une zone partielle de la première carte de circuit imprimé (120), et
où la première carte de circuit imprimé (120) inclut au moins une ligne de signal configurée pour connecter électriquement le processeur (720) et le premier en-tête (121).

10. Dispositif électronique selon la revendication 1, où le premier module (210) est monté sur la première carte de circuit imprimé (120), sur la base d'un engagement du premier en-tête (121) et de la première prise (211), et
où le deuxième module (220) est empilé verticalement sur le premier module (210), sur la base d'un engagement du deuxième en-tête (213) et de la deuxième prise (221).

11. Dispositif électronique selon la revendication 1, où le premier module (210) inclut en outre une première partie électronique (30) configurée pour effectuer la première fonction,
où le deuxième module (220) inclut en outre une deuxième partie électronique (40) configurée pour effectuer la deuxième fonction, et
où le processeur (720) est en outre configuré pour :
recevoir un signal d'événement lié à une performance de la première fonction ou une performance de la deuxième fonction ;
identifier une partie électronique connexe, sur la base du signal d'événement ;
transférer au moins un premier signal de commande lié à la performance de la première fonction à la première partie électronique (30) par l'intermédiaire d'au moins l'un parmi le premier en-tête (121) ou la première prise (211) lorsqu'un résultat de l'identification montre que le signal d'événement est lié à la première partie électronique (30) ; et
transférer au moins un deuxième signal de commande lié à la performance de la deuxième fonction à la deuxième partie électronique (40) par l'intermédiaire d'au moins l'un parmi un premier en-tête (121), la première prise (211), le deuxième en-tête (213), ou la deuxième prise (221) lorsque le résultat de l''identification montre que le signal d'événement est lié à la deuxième partie électronique (40).

12. Dispositif électronique selon la revendication 11, où le premier module (210) est monté sur la première carte de circuit imprimé (120), sur la base d'un engagement du premier en-tête (121) et de la première prise (221), et
où le deuxième module (220) est empilé verticalement sur le premier module (210), sur la base d'un engagement du deuxième en-tête (213) et de la deuxième prise (221).

13. Dispositif électronique selon la revendication 11, où le premier module (210) inclut en outre une deuxième carte de circuit imprimé (215) ayant au moins une ligne de signal configurée pour connecter électriquement la première prise (211) et la première partie électronique (30).

14. Dispositif électronique selon la revendication 11, où le deuxième module (220) inclut en outre une troisième carte de circuit imprimé (223) ayant au moins une ligne de signal configurée pour connecter électriquement la deuxième prise (221) et la deuxième partie électronique (40).

15. Dispositif électronique selon la revendication 1, où la pluralité de troisièmes bornes est disposée dans la première prise (211), et
où au moins quelques-unes de la pluralité de premières bornes s'étendent à travers la première prise (211) afin d'être électriquement connectées aux troisièmes bornes.
